# EUROPÄISCHE PATENTSCHRIFT

(11) **EP 2 508 902 B1**
(45) Veröffentlichungstag und Bekanntmachung des Hinweises auf die Patenterteilung: **17.01.2018**
(21) Anmeldenummer: 12002417.9
(22) Anmeldetag: 03.04.2012
(51) Int. Cl.: H01R 12/89, G01R 31/28

(54) **Testkontaktor für eine Leiterplatte, Verwendung und Verfahren zum Prüfen**
Test contactor for a circuit board, use and test method
Contacteur d'essai pour une plaquette, utilisation et procédé de vérification

(30) Priorität: 07.04.2011 DE 102011016299
(43) Veröffentlichungstag der Anmeldung: 10.10.2012
(73) Patentinhaber: Yamaichi Electronics Deutschland GmbH, 85609 Aschheim-Dornach (DE)
(72) Erfinder: Serna, Yoan, 81543 München (DE)
(74) Vertreter: Müller-Boré & Partner Patentanwälte PartG mbB

(56) Entgegenhaltungen:
- EP-A2- 0 717 468
- US-A- 5 795 172
- US-A- 6 130 547

## Beschreibung

Die vorliegende Erfindung betrifft einen Testkontaktor für eine Leiterplatte, eine Verwendung des Testkontaktors und ein Verfahren zum Prüfen einer Leiterplatte.

Unter einer Leiterplatte wird im Sinne dieser Anmeldung eine Leiterplatte bzw. Platine für eine gedruckte Schaltung (auch "PCB", "printed circuit board" genannt) verstanden. Eine Leiterplatte kann ein oder mehrere elektrische und/oder elektronische Bauteile, wie beispielsweise integrierte Schaltkreise (auch "IC", "integrated circuit" genannt), Widerstände, Kondensatoren, Dioden, Transistoren usw. umfassen.

Herkömmlicherweise werden gedruckte Schaltungen nach der Herstellung auf Funktionsfähigkeit geprüft. Viele Leiterplatten von gedruckten Schaltungen weisen Platinenrandkontakte (engl.: "edgeboard contact") auf, so daß die Leiterplatten durch ein Einführen ihres Randes in einen Platinenverbinder elektrisch und mechanisch mit einer Mutterleiterplatte (auch "Motherboard") verbindbar ist. Damit die elektrische und mechanische Verbindung dauerhaft ist, müssen die Kontakte des Platinenverbinders eine vorbestimmte Kontaktkraft auf die Platinenrandkontakte der eingeführten Leiterplatte anlegen, was dazu führt, daß das Einführen mit einem hohen Kraftaufwand erfolgt, welcher notwendig ist, um die Kontakte des Platinenverbinders auseinander zu drücken. Dabei tritt ebenfalls beim Einführen eine Reibung zwischen den Kontakten des Platinenverbinders und den Platinenrandkontakten der Leiterplatte auf.

Zur Prüfung von Leiterplatten werden diese in einen Platinenverbinder einer Prüfplatine geschoben, geprüft und anschließend wieder entfernt. Mitunter findet die Prüfung der Leiterplatten automatisiert in Prüfautomaten statt, so daß die einzelnen für die Prüfung notwendigen Betriebszustände durch den Prüfautomaten herstellbar sein sollten. Aufgrund der häufigen Leiterplattenwechsel und der dabei auftretenden Abrasion der Kontakte des Platinenverbinders der Prüfplatine besitzt die Prüfplatine eine sehr begrenzte Lebensdauer.

Die Druckschrift US 5 795 172 B offenbart einen Verbinder, in welchen eine Kante einer Leiterplatte kraftlos einführbar ist. Der Verbinder weist eine Vielzahl gegenüberliegender elektrischer Kontakte auf, welche nach dem Einführen der Leiterplatte durch einen Hebelmechanismus aufeinander zu bewegt werden können, um die elektrischen Kontakte auf zugeordnete Kontaktflächen der Leiterplatte zu pressen.

Die Druckschrift US 6 130 547 B offenbart eine Testvorrichtung, welche eine fixierte Kontaktnadel und eine gegenüberliegende bewegliche Kontaktnadel aufweist. Die vorstehende fixierte Kontaktnadel kann durch das Anordnen einer Leiterplatte an die Testvorrichtung mit einer zugeordneten Kontaktfläche auf einer ersten Seite der Leiterplatte elektrisch kontaktieren. Die gegenüberliegende bewegliche Kontaktnadel steht zunächst nicht vor und kann erst durch Anpressen der Testvorrichtung an einer zweiten Seite der Leiterplatte, die der ersten Seite gegenüberliegt, mit einer zugeordneten Kontaktfläche der zweiten Seite kontaktiert werden.

Die Druckschrift EP 0 717 468 A2 offenbart einen Stecker, welcher drei elektrische Kontakt aufweist, wobei der mittlere elektrische Kontakt entlang einer Steckrichtung des Steckers gegenüber den anderen Kontakten vorragt. Der mittlere elektrische Kontakt ist als Massekontakt vorgesehen, damit die Masseverbindung beim Ziehen des Steckers zuletzt unterbrochen wird.

Es ist eine Aufgabe der Erfindung, einen Testkontaktor, eine Verwendung des Testkontaktors sowie ein Verfahren zum Prüfen von Leiterplatten bereitzustellen, wodurch die Prüfung von Leiterplatten in großer Stückzahl und in einfacher, sicherer und effizienter Weise ermöglicht wird.

Diese Aufgabe wird durch einen Testkontaktor mit den Merkmalen des Anspruchs 1, eine Verwendung des Testkontaktors mit den Merkmalen des Anspruchs 9 und ein Verfahren zum Prüfen von Leiterplatten mit den Merkmalen des Anspruchs 10 gelöst. Bevorzugte Ausführungsformen sind Gegenstand der abhängigen Ansprüche.

### Testkontaktor gemäß einem Aspekt

Ein Aspekt der vorliegenden Erfindung betrifft einen Testkontaktor zum Kontaktieren einer Leiterplatte umfassend:
- ein erstes Andruckelement mit einer ersten Leiterplattenkontaktseite und zumindest einem ersten Kontaktelement;
- ein zweites Andruckelement mit einer zweiten Leiterplattenkontaktseite, wobei das zweite Andruckelement relativ zu dem ersten Andruckelement entlang einer Verlagerungsrichtung V verlagerbar ist,
wobei in einer Offenposition die erste Leiterplattenkontaktseite um einen Abstand d_{O} von der zweiten Leiterplattenkontaktseite im Bereich des zumindest einen ersten Kontaktelements entlang der Verlagerungsrichtung V beabstandet ist, so daß die Leiterplatte zwischen der ersten Leiterplattenkontaktseite und der zweiten Leiterplattenkontaktseite zumindest bereichsweise entlang einer Einführrichtung E kontaktfrei einführbar ist,
wobei in einer Betriebsposition die erste Leiterplattenkontaktseite um einen Abstand d_{B} von der zweiten Leiterplattenkontaktseite im Bereich des zumindest einen ersten Kontaktelements entlang der Verlagerungsrichtung V beabstandet ist, der kleiner als der Abstand do ist, so daß das zumindest eine erste Kontaktelement mit zumindest einem zugeordneten ersten Platinenrandkontakt der Leiterplatte kontaktierbar ist und wobei der Testkontaktor durch eine relative Verlagerung der zwei Andruckelemente entlang der Verlagerungsrichtung V von der Offenposition in die Betriebsposition überführbar ist.

Vorteilhafterweise ist die Leiterplatte kontaktfrei in den Zwischenraum zwischen der ersten Leiterplattenkontaktseite und der zweiten Leiterplattenkontaktseite einführbar. Der Begriff "kontaktfrei" im Sinne der Anmeldung bedeutet, daß das zumindest eine erste Kontaktelement beim Einführen der Leiterplatte in der Offenposition nicht in Kontakt mit der Leiterplatte gelangt. Der elektrische und mechanische Kontakt des zumindest einen Kontaktelement mit der Leiterplatte ist erst durch das Überführen des Testkontaktors in die Betriebsposition herstellbar.

Insbesondere bewirkt das kontaktfreie Einführen der Leiterplatte in den Testkontaktor, daß keine Reibung zwischen dem zumindest einen ersten Kontaktelement und der Leiterplatte auftritt. Daher ist die Leiterplatte insbesondere in dem Sinne kraftfrei in den Testkontaktor einführbar, daß kein Reibungswiderstand zwischen der Leiterplatte und dem zumindest einen ersten Kontaktelement zu überwinden ist. Beispielsweise kann die Leiterplatte lediglich aufgrund der Schwerkraft in den Zwischenraum fallen. Mit anderen Worten tritt beim Einführen der Leiterplatte entlang der Einführrichtung E keine Reibung auf, welche durch einen Kraftaufwand überwunden werden muß. Der Abstand d_{O} ist derart bemessen, daß die Leiterplatte in der Offenposition kontaktfrei, insbesondere ohne einen Reibschluß mit dem ersten und zweiten Andruckelement, entlang der Einführrichtung E einführbar ist. Beispielsweise kann der Abstand d_{O} zumindest etwa 3 mm, bevorzugt zumindest etwa 5 mm oder zumindest etwa 10 mm betragen. Insbesondere kann der Abstand d_{O} etwa 4 mm, beispielsweise 4,1 mm, betragen. Das zumindest eine erste Kontaktelement ragt bevorzugt entlang der Verlagerungsrichtung über die erste Leiterplattenkontaktseite hervor, insbesondere um etwa 0,1 mm bis etwa 2 mm, weiter bevorzugt um etwa 0,5 mm bis etwa 1 mm. Dem entsprechend kann ein Abstand d_{K} in der Offenposition zwischen dem zumindest einen ersten Kontaktelement und der zweiten Leiterplattenkontaktseite zumindest etwa 2,5 mm oder zumindest etwa 3 mm, bevorzugt zumindest etwa 4,5 mm oder zumindest etwa 8 mm betragen. Insbesondere kann der Abstand d_{K} zwischen etwa 3,3 mm und etwa 3,4 mm betragen, insbesondere 3,36 mm. Erst in der Betriebsposition sind das zumindest eine erste Kontaktelement und der zumindest eine zugeordnete erste Platinenrandkontakt der Leiterplatte miteinander kontaktiert und insbesondere in Reibschluß miteinander. Da beim Einführen und Dekontaktieren der Leiterplatte keine abrasive Beanspruchung des zumindest einen ersten Kontaktelements erfolgt, ist der zumindest eine erste Kontakt in der Regel verschleißfrei.

Der Testkontaktor weist das erste Andruckelement und das zweite Andruckelement auf, welche entlang der Verlagerungsrichtung V relativ zueinander verlagerbar sind. Mit anderen Worten sind beide Andruckelemente relativ zueinander linear verschiebbar. Dabei können bevorzugt das erste und zweite Andruckelement verlagerbar bzw. linear verschiebbar ausgebildet bzw. angeordnet sein. Insbesondere können sich das erste und zweite Andruckelement gegenläufig entlang der Verlagerungsrichtung V bewegen, um von der Offenposition in die Betriebsposition zu gelangen. In der Anmeldung wird nicht zwischen einer Verlagerung entlang und entgegen der Verlagerungsrichtung V unterschieden, da sich beide Andruckelemente gegenläufig bewegen. Alternativ könnte auch lediglich das erste Andruckelement oder das zweite Andruckelement verlagerbar bzw. verschiebbar ausgebildet sein, während das jeweilige andere Andruckelement ortsfest an dem Testkontaktor montiert ist. Zwischen dem ersten und zweiten Andruckelement befindet sich in der Offenposition des Testkontaktors ein Zwischenraum, in welchen die Leiterplatte zumindest bereichsweise entlang der Einführrichtung E einführbar ist. Einführrichtung E und Verlagerungsrichtung V stehen bevorzugt senkrecht zueinander.

An der ersten Leiterplattenkontaktseite des ersten Andruckelements, welche dem Zwischenraum zugewandt ist, ist zumindest ein erstes Kontaktelement angeordnet. Es versteht sich, daß an der ersten Leiterplattenkontaktseite auch zwei, drei, vier, fünf, ..., zehn, ..., hundert, hundertfünf, hundertfünfzehn usw. erste Kontaktelemente ausgebildet bzw. angeordnet sein können. Dagegen kann die zweite Leiterplattenkontaktseite frei von Kontaktelementen sein. Es versteht sich, daß in diesem Fall lediglich Leiterplatten mittels des Testkontaktors vollständig elektrisch kontaktiert werden können, die nur auf einer entsprechenden Leiterplattenseite Platinenrandkontakte aufweisen.

Der Abstand d_{B} zwischen der ersten Leiterplattenkontaktseite und der zweiten Leiterplattenkontaktseite entlang der Verlagerungsrichtung V ist kleiner als der Abstand d_{O}. Beispielsweise kann der Abstand d_{B} zumindest etwa 2 mm, bevorzugt zumindest etwa 1,5 mm oder zumindest etwa 1 mm betragen, beispielsweise etwa 1,2 mm oder etwa 1,1 mm. Aufgrund des Kontaktierens des zumindest einen ersten Kontaktelements mit der Platine, ist der Abstand zwischen dem zumindest einen ersten Kontaktelement und der zweiten Leiterplattenkontaktseite von der Dicke der Leiterplatte abhängig. Insbesondere kann der Abstand d_{B} im wesentlichen gleich der Leiterplattendicke sein. Der Begriff "im wesentlichen" bedeutet hier, daß der Abstand d_{B} bis etwa 0,1 mm größer sein kann als die Dicke der Leiterplatte, um ein Spiel in der Betriebsposition vorzusehen. Typischerweise beträgt die Leiterplattendicke 0,8 mm bis 1,6 mm, insbesondere, 0,8 mm, 1,0 mm, 1,55 mm und 1,6 mm. Dem entsprechend kann ein Abstand d_{K} in der Betriebsposition zwischen dem zumindest einen ersten Kontaktelement und der zweiten Leiterplattenkontaktseite etwa 0,8 mm bis etwa 1,6 mm betragen. Mit anderen Worten werden das erste und zweite Andruckelement aufeinander zu verlagert, um von der Offenposition zur Betriebsposition zu gelangen. Dabei gelangt das zumindest eine erste Kontaktelement mit dem zumindest einem zugeordneten ersten Platinenrandkontakt der Leiterplatte in einen elektrischen und mechanischen Kontakt. Dabei kann jedes der zumindest einen ersten Kontaktelemente eine vorbestimmte Andruckkraft F_{K} auf der zugeordneten Platinenrandkontakt anlegen, wodurch vorteilhafterweise ein vorbestimmter Übergangswiderstand erreicht bzw. unterschritten wird. Der Begriff "Betriebsposition" beschreibt demnach einen Zustand des Testkontaktors, in welchem die zu prüfende Leiterplatte derart elektrisch kontaktiert ist, daß eine elektrische Prüfung der Funktion der Leiterplatte mittels des Testkontaktors durchführbar ist, also der betriebsgemäße Gebrauch des Testkontaktors möglich ist.

Davon zu unterscheiden ist eine Geschlossenposition, wobei keine Leiterplatte in den Testkontaktor eingeführt ist und auch keine Leiterplatte in den Testkontaktor einführbar ist. Der Abstand d_{G} zwischen der ersten Leiterplattenkontaktseite und der zweiten Leiterplattenkontaktseite entlang der Verlagerungsrichtung V in der Geschlossenposition ist kleiner als der Abstand d_{O} und kann kleiner sein als der Abstand d_{B} in der Betriebsposition. Insbesondere kann der Abstand d_{G} null sein.

### Bevorzugte Ausführunasformen des Testkontaktors

Vorzugsweise umfaßt das zweite Andruckelement zumindest ein zweites Kontaktelement, wobei das zumindest eine zweite Kontaktelement in der Betriebsposition mit zumindest einem zugeordneten zweiten Platinenkantenkontakt der Leiterplatte kontaktierbar ist.

In der Betriebsposition sind das zumindest eine zweite Kontaktelement und der zumindest eine zugeordnete zweite Platinenrandkontakt der Leiterplatte miteinander kontaktiert und insbesondere in Reibschluß miteinander. Vorteilhafterweise ist die Leiterplatte kontaktfrei zu dem zumindest einen zweiten Kontaktelement in den Zwischenraum zwischen der ersten Leiterplattenkontaktseite und der zweiten Leiterplattenkontaktseite einführbar. Das kontaktfreie Einführen der Leiterplatte in den Testkontaktor verhindert eine Reibung zwischen dem zumindest einen zweiten Kontaktelement und der Leiterplatte. Das zumindest eine zweite Kontaktelement ist wie das zumindest eine erste Kontaktelement im wesentlichen verschleißfrei, da sowohl beim Einführen als auch beim Dekontaktieren der Leiterplatte keine abrasive Beanspruchung des zumindest einen zweiten Kontaktelements erfolgt.

Das zumindest eine erste Kontaktelement des ersten Andruckelements und das zumindest eine zweite Kontaktelement des zweiten Andruckelements sind bevorzugt gegenüberliegend angeordnet, so daß die Leiterplatte beim Einführen in den Testkontaktor entlang der Einführrichtung E zwischen dem zumindest einen ersten Kontaktelement und dem zumindest einen zweiten Kontaktelement anordenbar bzw. angeordnet ist. Mit anderen Worten können das zumindest eine erste Kontaktelement und das zumindest eine zweite Kontaktelement in der Betriebsposition jeweils zugeordnete Platinenrandkontakte der Leiterplatten kontaktieren, wobei der zumindest eine erste Platinenrandkontakt, welcher dem zumindest einen ersten Kontaktelement zugeordnet ist, auf der Seite der Leiterplatte angeordnet ist, welche der Seite der Leiterplatte gegenüberliegt, auf welcher sich der zumindest eine zweite Platinenrandkontakt befindet, welcher dem zumindest einen zweiten Kontaktelement zugeordnet ist. Mit anderen Worten können das(die) erste(n) Kontaktelement(e) und das(die) zweite(n) Kontaktelement(e) in der Betriebsposition zugeordnete Platinenrandkontakte auf gegenüberliegenden bzw. entgegengesetzten Seiten der Leiterplatte kontaktieren.

Bevorzugt ist die Anzahl der zweiten Kontaktelemente gleich der Anzahl der ersten Kontaktelemente. Entsprechend kann das zweite Andruckelement an der zweiten Leiterplattenkontaktseite zwei, drei, vier, fünf, ..., zehn, ..., hundert, hundertfünf, hundertfünfzehn usw. zweite Kontaktelemente aufweisen.

Um zwischen der Offenposition und der Betriebsposition zu wechseln sind die ersten und zweiten Kontaktelemente entlang der Verlagerungsrichtung V verlagerbar, insbesondere linear verschiebbar. Das zumindest eine zweite Kontaktelement ragt bevorzugt entlang der Verlagerungsrichtung über die erste Leiterplattenkontaktseite hervor, insbesondere um etwa 0,1 mm bis etwa 2 mm, weiter bevorzugt um etwa 0,5 mm bis etwa 1 mm. Dem entsprechend kann ein Abstand d_{K} in der Offenposition zwischen dem zumindest einen ersten Kontaktelement und dem zumindest einen zweiten Kontaktelement beispielsweise zumindest etwa 2 mm oder zumindest etwa 2,5 mm, bevorzugt zumindest etwa 4 mm, zumindest etwa 8 mm betragen, insbesondere etwa 3,36 mm. Vorzugsweise beträgt der Abstand d_{K} zwischen dem zumindest einen ersten Kontaktelement und dem zumindest einen zweiten Kontaktelement in der Offenposition zwischen etwa 2 mm und etwa 10 mm, bevorzugt zwischen etwa 3 mm und etwa 5 mm, so daß eine zu prüfende Leiterplatte zumindest bereichsweise entlang der Einführrichtung E zwischen die ersten und zweiten Kontaktelemente einführbar ist. Weiter bevorzugt lassen sich die ersten und zweiten Kontaktelemente entlang der Verlagerungsrichtung V derart verlagern, daß der Abstand d_{K} zwischen dem zumindest einen ersten Kontaktelement und dem zumindest einen zweiten Kontaktelement in der Betriebsposition zwischen etwa 0,5 mm und etwa 1,6 mm, bevorzugt etwa 1 mm beträgt. Es versteht sich, daß der Abstand d_{K} zwischen den ersten und zweiten Kontaktelementen in der Betriebsposition durch die dazwischen angeordnete Leiterplatte durch die Dicke der Leiterplatte nach unten begrenzt ist. Mit anderen Worten kann der Abstand d_{K} nicht kleiner als die Dicke der Leiterplatte sein.

Vorzugsweise weist das erste Andruckelement zumindest ein erstes Massekontaktelement auf, welches ausgehend von der ersten Leiterplattenkontaktseite entlang der Verlagerungsrichtung V weiter vorragt als das zumindest eine erste Kontaktelement. Weiter vorzugsweise weist das zweite Andruckelement zumindest ein zweites Massekontaktelement auf, welches ausgehend von der zweiten Leiterplattenkontaktseite entlang der Verlagerungsrichtung V weiter vorragt als das zumindest eine zweite Kontaktelement. Der Begriff des "kontaktfreien Einführens der Leiterplatte" bedeutet bei Vorhandensein von ersten und/oder zweiten Massekontakten auch, daß die Leiterplatte beim Einführen in den Testkontaktor in der Offenposition die ersten und/oder zweiten Massekontakte nicht mechanisch bzw. elektrisch kontaktiert.

Vorteilhafterweise ist ein zugeordneter erster Platinenrandmassekontakt der zu prüfenden Leiterplatte durch das zumindest eine erste Massekontaktelement kontaktierbar bevor das zumindest eine erste Kontaktelement den zugeordneten ersten Platinenrandkontakt der Leiterplatte kontaktiert. Entsprechend ist ein zugeordneter zweiter Platinenrandmassekontakt der zu prüfenden Leiterplatte durch das zumindest eine zweite Massekontaktelement kontaktierbar bevor das zumindest eine zweite Kontaktelement den zugeordneten zweiten Platinenrandkontakt der Leiterplatte kontaktiert. Dadurch ist die zu prüfende Leiterplatte bei dem Übergang des Testkontaktor von der Offenposition in die Betriebsposition mit Masse bzw. mit dem Nullpotential elektrisch verbindbar bevor spannungsführende bzw. stromführende erste und/oder zweite Kontaktelemente des Testkontaktors mit der Leiterplatte in elektrischem Kontakt treten. Vorteilhafterweise kann eine Beschädigung der Leiterplatte durch Spannungsspitzen während der Prüfung vermieden werden. Entsprechend verbleiben das zumindest eine erste Massekontaktelement und/oder das zumindest eine zweite Massekontaktelement bei einer Verlagerung des ersten und zweiten Andruckelements von der Betriebsposition in die Offenposition noch mit der Leiterplatte in elektrischem Kontakt, während der elektrische Kontakt zwischen der Leiterplatte und dem zumindest einen ersten Kontaktelement und/oder dem zumindest einen zweiten Kontaktelement bereits getrennt ist.

Bevorzugt können das zumindest eine erste Massekontaktelement und/oder das zumindest eine zweite Massekontaktelement um etwa 0,05 mm bis etwa 2 mm, weiter bevorzugt um etwa 0,1 mm bis etwa 2 mm, insbesondere um etwa 0,33 mm oder um etwa 0,5 mm, entlang der Verlagerungsrichtung V gegenüber dem zumindest einen ersten Kontaktelement und/oder gegenüber dem zumindest einen zweiten Kontaktelement vorragen.

Vorzugsweise sind das zumindest eine erste Kontaktelement und/oder das zumindest eine zweite Kontaktelement rückstellfähig ausgebildet, wobei das zumindest eine erste Kontaktelement und/oder das zumindest eine zweite Kontaktelement in der Betriebsposition eine vorbestimmte Andruckkraft F_{K} auf die Leiterplatte anlegt. Weiter bevorzugt sind das zumindest eine erste Massekontaktelement und/oder das zumindest eine zweite Massekontaktelement rückstellfähig ausgebildet. Entsprechend ist mittels des zumindest einen ersten Massekontaktelements und/oder mittels des zumindest einen zweiten Massekontaktelements in der Betriebsposition eine vorbestimmte Andruckkraft F_{M} auf die Leiterplatte anlegbar.

Vorteilhafterweise kann jedes einzelne Kontaktelement bzw. Massekontaktelement des Testkontaktors in der Betriebsposition aufgrund der angelegten Andruckkraft derart an einen zugeordneten Platinenrandkontakt bzw. Platinenrandmassekontakt der Leiterplatte in elektrisch kontaktierender Weise gepreßt sein, um den Übergangswiderstand an dem ausgebildeten elektrischen Kontakt unterhalb eines bestimmten Grenzwertes zu halten.

Der Begriff "rückstellfähig" im Sinne der Anmeldung umfaßt insbesondere, daß die ersten und zweiten Kontaktelemente elastisch verformbar ausgebildet sind. Rückstellfähig bedeutet in diesem Zusammenhang, daß ein Körper durch Einwirkung einer äußeren Kraft verformbar ist, wobei sich die Verformung im wesentlichen vollständig zurückbildet, wenn die äußere Kraft nicht mehr wirkt, das heißt, daß der Körper nach dem Wirken der äußeren Kraft im wesentlichen zu seiner ursprünglichen Gestalt zurückkehrt.

Bevorzugt sind das zumindest eine erste Kontaktelement und/oder zumindest eine erste Massekontaktelement entlang der Verlagerungsrichtung V derart rückstellfähig bzw. elastisch verformbar, daß das entsprechende Kontaktelement bzw. Massekontaktelement mit der ersten Leiterplattenkontaktseite bündig bzw. eben abschließt. Weiter bevorzugt sind das zumindest eine zweite Kontaktelemente und/oder das zumindest eine zweite Massekontaktelement entlang der Verlagerungsrichtung V derart rückstellfähig bzw. elastisch verformbar, daß das entsprechende Kontaktelement bzw. Massekontaktelement mit der zweiten Leiterplattenkontaktseite bündig bzw. eben abschließt. Vorteilhafterweise können die erste und zweite Leiterplattenkontaktseite dann in der Geschlossenposition einander mechanisch kontaktieren, d.h. daß der Abstand d_{G} gleich null ist.

Die Andruckkraft F_{K}, welche mittels der ersten und/oder zweiten Kontaktelemente auf die Leiterplatte anlegbar ist, beträgt vorzugsweise etwa 0,05 N bis etwa 0,5 N, weiter bevorzugt etwa 0,1 N bis etwa 0,3 N und insbesondere etwa 0,2 N für jedes der Kontaktelemente. Entsprechend beträgt die Andruckkraft F_{M}, welche mittels der ersten und/oder zweiten Massekontaktelemente auf die Leiterplatte anlegbar ist, vorzugsweise etwa 0,05 N bis etwa 0,5 N, weiter bevorzugt etwa 0,1 N bis etwa 0,3 N und insbesondere etwa 0,2 N für jedes der Massekontaktelemente. Die gesamte Andruckkraft, welche an eine Seite der Leiterplatte anlegbar ist, ergibt sich durch Multiplikation der Andruckkraft F_{K} mit der Anzahl der ersten oder zweiten Kontaktelemente gegebenenfalls zuzüglich der Andruckkraft F_{M} multipliziert mit der Anzahl der ersten oder zweiten Massekontaktelemente. Die resultierende Gesamtandruckkraft, die mittels des ersten bzw. zweiten Andruckelements an die Leiterplatte anlegbar ist, kann in einem Bereich zwischen etwa 1 N und etwa 500 N liegen.

Die rückstellfähigen Kontaktelemente bzw. Massekontaktelemente können bevorzugt einstückig ausgebildet sein, beispielsweise als federelastisches, elektrisch leitfähiges Element mit einem ersten Schenkel, einem Biegebereich und mit einem zweiten Schenkel. Der erste Schenkel ist an dem ersten oder zweiten Andruckelement befestigt. Der zweite Schenkel wird vorzugsweise über den Biegebereich mit dem ersten Schenkel verbunden. Dabei ist der zweite Schenkel gegenüber dem ersten Schenkel durch den Biegebereich um eine Biegeachse verschwenkbar, wenn eine Kraft entlang der Verlagerungsrichtung V auf den zweiten Schenkel angelegt wird, wobei insbesondere der Biegebereich elastisch verformt ist. Der Biegebereich ist vorzugsweise zumindest teilweise als Kreisbogen ausgebildet, wobei der Biegebereich bevorzugt um etwa 90 Grad bis etwa 180 Grad, besonders bevorzugt etwa 135 Grad bis etwa 170 Grad, insbesondere etwa 160 Grad bis 170 Grad, gebogen ist. Der elektrische Kontakt ist bevorzugt über den zweiten Schenkel, den Biegebereich und den ersten Schenkel hergestellt.

Die rückstellfähigen Kontaktelemente bzw. Massekontaktelemente können bevorzugt mehrstückig ausgebildet sein, beispielsweise umfassend einen Kontaktstift, welcher in einer Kontakthülse federnd gelagert ist. Die Kontakthülse ist bevorzugt derart an bzw. in dem ersten bzw. zweiten Andruckelement befestigt, daß der Kontaktstift entlang der Verlagerungsrichtung V in der Kontakthülse beweglich ist. Mittels einer Kontaktfeder, insbesondere einer Kontaktfeder im Inneren der Kontakthülse, erfolgt die federnde Lagerung des Kontaktstiftes derart, daß durch ein Eindrücken des Kontaktstiftes in die Kontakthülse eine Kompression der Kontaktfeder erfolgt und die Kontaktfeder dadurch eine entsprechende Gegenkraft erzeugt. Die Kontaktfeder kann beispielsweise eine Spiralfeder sein. In der Betriebsposition erzeugt die Kontaktfeder die vorbestimmte Andruckkraft des Kontaktelements bzw. Massekontaktelements an die Leiterplatte. Der Kontaktstift und die Kontakthülse, gegebenenfalls auch die Kontaktfeder, sind aus einem elektrisch leitfähigen Material ausgebildet, beispielsweise einem Metall.

Vorzugsweise ist das zumindest eine erste Kontaktelement mittels einer flexiblen ersten elektrischen Leitung mit einer Testkontaktorleiterplatte elektrisch verbunden. Weiter vorzugsweise ist das zumindest eine zweite Kontaktelement mittels einer flexiblen zweiten elektrischen Leitung mit der Testkontaktorleiterplatte elektrisch verbunden. Besonders bevorzugt ist die zweite elektrische Leitung gleich lang zu der ersten elektrischen Leitung.

Vorteilhafterweise können durch die Verwendung einer ersten und zweiten elektrischen Leitung gleicher Länge unterschiedliche Phasenverzögerungen von Signalen zwischen der Leiterplatte und der Testkontaktorleiterplatte vermieden werden, die über unterschiedliche elektrische Leitungen übertragen werden.

Die erste elektrische Leitung ist mit dem zumindest einen ersten Kontaktelement und bevorzugt mit dem zumindest einen ersten Massekontaktelement des ersten Andruckelements kontaktiert und insbesondere mit bzw. an dem ersten Andruckelement mechanisch fixiert. Die zweite elektrische Leitung ist mit dem zumindest einen zweiten Kontaktelement und bevorzugt mit dem zumindest einen zweiten Massekontaktelement des zweiten Andruckelements kontaktiert und insbesondere mit bzw. an dem zweiten Andruckelement mechanisch fixiert.

Beispielsweise kann die erste bzw. zweite elektrische Leitung eine Trägerfolie umfassen, auf welcher elektrische Leitungen ausgebildet sind. Bevorzugt erstreckt sich die Trägerfolie in einer Breitenrichtung B, welche im wesentlichen senkrecht zur Verlagerungsrichtung V und senkrecht zur Einführrichtung E steht. Weiter bevorzugt ist die Trägerfolie der ersten elektrischen Leitung derart ausgebildet und angeordnet, daß bei der Verlagerung des ersten Andruckelements die Trägerfolie der ersten elektrischen Leitung lediglich eine Biegung entlang einer Biegeachse parallel zur Breitenrichtung B erfährt. Entsprechend ist die Trägerfolie der zweiten elektrischen Leitung derart ausgebildet und angeordnet, daß bei der Verlagerung des zweiten Andruckelements die Trägerfolie der zweiten elektrischen Leitung lediglich eine Biegung entlang einer Biegeachse parallel zur Breitenrichtung B erfährt.

Die Testkontaktorleiterplatte kann weitere elektronische Bauteile aufweisen, welche benötigt werden, um eine elektrische Prüfung der Leiterplatte durchzuführen. Insbesondere kann die Testkontaktorleiterplatte eine elektrische oder optische Schnittstelle zu einem externen Prüfgerät aufweisen. Beispielsweise kann die Schnittstelle der Norm Q7 entsprechen. Vorteilhafterweise ermöglicht eine räumliche Trennung zwischen des Testkontaktors und des Prüfgeräts eine Prüfung der Leiterplatte unter Bedingungen, bei denen die Elektronik des Prüfgerätes Schaden nehmen würde, beispielsweise bei niedrigen Temperaturen bis -25 Grad Celsius, bei erhöhten Temperaturen bis etwa 120 Grad Celsius oder unter Vibrationen.

Vorzugsweise umfaßt der Testkontaktor eine erste Vorspanneinrichtung, welche das erste Andruckelement entlang der Verlagerungrichtung V mechanisch vorspannt und/oder eine zweite Vorspanneinrichtung, welche das zweite Andruckelement entlang der Verlagerungrichtung V mechanisch vorspannt.

Vorteilhafterweise kann mittels der ersten und/oder zweiten Vorspanneinrichtung eine Vorspannkraft entlang der Verlagerungsrichtung V auf das erste und/oder zweite Andruckelement angelegt werden, so daß die Leiterplatte in der Betriebsposition aufgrund dieser Vorspannkraft zwischen dem ersten und zweiten Andruckelement festgeklemmt ist. Die erste und/oder zweite Vorspanneinrichtung umfaßt/umfassen bevorzugt Federn, beispielsweise Spiralfedern, welche derart ausgebildet und angeordnet sind, daß die erste und/oder zweite Vorspanneinrichtung in der Offenposition des Testkontaktors stärker vorgespannt ist als in der Betriebsposition.

Vorzugsweise umfaßt der Testkontaktor eine Betätigungseinrichtung, mit welcher das erste Andruckelement und/oder das zweite Andruckelement verlagerbar ist. Insbesondere umfaßt die Betätigungseinrichtung zumindest eine exzentrische Kurvenscheibe, welche zwischen dem ersten und zweiten Andruckelement angeordnet ist und mit diesen mechanisch kontaktiert. Durch ein Drehen der Kurvenscheibe ist der Abstand zwischen dem ersten und zweiten Andruckelement einstellbar. Besonders bevorzugt sind zwischen dem ersten und dem zweiten Andruckelement zwei Kurvenscheiben an den beiden entgegengesetzten Seiten der Andruckelemente vorgesehen, wodurch vorteilhafterweise ein Verkanten verhindert wird. Die Kurvenscheibe(n) ist bzw. sind an einem zugeordneten Achsstummel angeordnet, welcher mittels eines Betätigungshebels drehbar ist. Vorzugsweise sind mittels eines einzigen Betätigunghebels zwei Achsstummel und die daran befestigten beiden Kurvenscheiben drehbar. Die Achsstummel können beispielsweise in einer reibungsarmen Kunststoffhülse im Gehäuse des Testkontaktors gelagert sein.

Bevorzugt ist zumindest ein erster Sicherungsstift an dem ersten Andruckelement angeordnet bzw. befestigt, welcher über die erste Leiterplattenkontaktseite entlang der Verlagerungsrichtung V vorragt und in eine zugeordnete gegenüberliegende komplementäre Sicherungsstiftöffnung des zweiten Andruckelements verschiebbar hineinragt. Weiter bevorzugt ist zumindest ein zweiter Sicherungsstift an dem zweiten Andruckelement angeordnet bzw. befestigt, welcher über die zweite Leiterplattenkontaktseite entlang der Verlagerungsrichtung V vorragt und in eine zugeordnete gegenüberliegende komplementäre Sicherungsstiftöffnung des ersten Andruckelements verschiebbar hineinragt.

Vorteilhafterweise kann dadurch das Einführen einer ungeeigneten Leiterplatte in den in Offenposition befindlichen Testkontaktor verhindert werden, welche nicht eine oder mehrere entsprechenden Kerbung(en) aufweisen, wobei in jede Kerbung ein zugeordneter Sicherungsstift einführbar ist. Beispielsweise können erste und/oder zweite Sicherungsstifte derart vorgesehen sein, daß lediglich Leiterplatte der Norm Q7 in den Testkontaktor einführbar sind.

### Verwendung gemäß einem Aspekt

Ein Aspekt der vorliegenden Erfindung betrifft eine Verwendung eines erfindungsgemäßen Testkontaktors zum Kontaktieren einer Leiterplatte, wobei in der Betriebsposition das zumindest eine erste Kontaktelement des erstes Andruckelements mit zumindest einem zugeordneten ersten Platinenrandkontakt der Leiterplatte kontaktiert ist.

Es versteht sich, daß bevorzugt auch zumindest ein zweites Kontaktelement, zumindest ein erste Massekontaktelement und/oder zumindest ein zweites Massekontaktelement mit der Leiterplatte kontaktiert sein können. Weiter können erste und/oder zweite Kontaktelemente bzw. erste und/oder zweite Massekontaktelemente über elektrischen Leitungen mit einer Testkontaktorleiterplatte und gegebenenfalls mit einem externen Prüfgerät elektrisch verbunden sein, um eine Prüfung der Leiterplatte durchzuführen.

### Verfahren gemäß einem Aspekt

Ein Aspekt der vorliegenden Erfindung betrifft ein Verfahren zum Prüfen einer Leiterplatte umfassend die Schritte:
- Bereitstellen eines erfindungsgemäßen Testkontaktors;
- kraftfreies Anordnen zumindest eines Randbereiches der Leiterplatte zwischen dem ersten Andruckelement und dem zweiten Andruckelement des Testkontaktors;
- Verlagern des ersten Andruckelements entlang der Verlagerungsrichtung V relativ zu dem zweiten Andruckelement, um den Testkontaktor in eine Betriebsposition zu überführen, wobei das zumindest eine erste Kontaktelement mit zumindest einem zugeordneten ersten Platinenrandkontakt der Leiterplatte kontaktiert wird;
- Prüfen der Leiterplatte;
- Verlagern des ersten Andruckelements entlang der Verlagerungsrichtung V relativ zu dem zweiten Andruckelement, um den Testkontaktor in eine Offenposition zu überführen und
- kraftfreies Entnehmen der Leiterplatte.

### Figurenbeschreibung

Bevorzugte Ausführungsformen eines Testkontaktors werden nachfolgend anhand begleitender Figuren beispielhaft beschrieben. Es zeigt:
- Figur 1: eine perspektivische Ansicht einer Ausführungsform eines Testkontaktors,
- Figur 2: einen Schnitt durch den in Figur 1 gezeigten Testkontaktor in der Geschlossenposition,
- Figur 3: einen Schnitt durch eine Betätigungseinrichtung des Testkontaktors,
- Figur 4: eine Explosionsteilansicht einer weiteren Ausführungsform eines Testkontaktors.

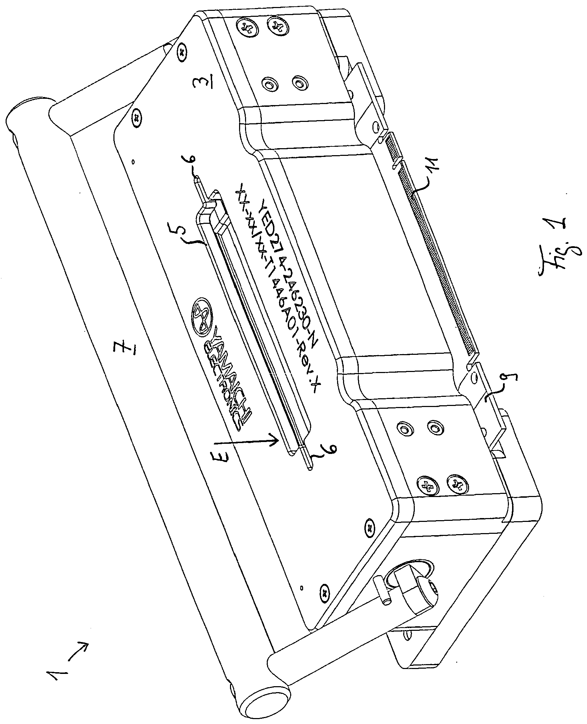

Figur 1 zeigt eine perspektivische Ansicht einer Ausführungsform eines Testkontaktors 1. Der Testkontaktor 1 weist ein Gehäuse 3 auf, in welchem eine Leiterplatteneinführöffnung 5 ausgebildet ist. Die Leiterplatteneinführöffnung umfaßt bevorzugt seitliche Einführnuten 6, welche ausgelegt sind die gegenüberliegenden Seiten einer Leiterplatte zu führen. Daher sind die Einführnuten 6 in etwa so breit ausgelegt, wie die Dicke der einzuführenden Leiterplatte, also etwa 1 mm bis etwa 2 mm. Wenn der Testkontaktor 1 sich in einer Offenposition befindet, kann eine Leiterplatte (nicht gezeigt) zumindest bereichsweise durch die Leiterplattenöffnung 5 des Gehäuses 3 in den Testkontaktor 1 entlang einer Einführrichtung E eingeführt werden. Mittels eines Betätigungshebels 7 ist der Testkontaktor von der Offenposition in eine Betriebsposition überführbar. Die in der Figur 1 gezeigte Ausführungsform des Testkontaktors 1 ist in einer Geschlossenposition dargestellt, das heißt, daß keine Leiterplatte in den Testkontaktor 1 eingeführt ist und in dieser Position auch nicht eingeführt werden kann. Zum Überführen des Testkontaktors 1 in die Offenposition wird der Betätigungshebel 7 nach unten gedrückt, so daß beim Erreichen der Offenposition zumindest ein Randbereich der Leiterplatte (nicht gezeigt) in die Leiterplatteneinführöffnung 5 des Gehäuses 3 entlang der Einführrichtung E einführbar ist. Nach dem Einführen der Leiterplatte wird der Betätigungshebel 7 losgelassen, wobei eine Kontaktierung der eingeführten Leiterplatte mit dem Testkontaktor 1 erfolgt. Um eine Funktionsprüfung der kontaktierten Leiterplatte durchzuführen, kann der Testkontaktor 1 eine geeignete Prüfelektronik aufweisen. Die in der Figur 1 gezeigte Ausführungsform des Testkontaktors 1 umfaßt eine Testkontaktorleiterplatte 9, die eine Schnittstelle 11 aufweist, mit welcher ein externes Prüfgerät (nicht gezeigt) mit dem Testkontaktor 1 verbunden werden kann. Die Prüfung der Leiterplatte erfolgt dann mittels des externen Prüfgeräts. Die Testkontaktorleiterplatte 9 kann weitere elektrische oder elektronische Bauteile aufweisen, die nötig sind, um die Leiterplatte mit dem externen Prüfgerät zu verbinden, wie beispielsweise Bauteile zur Anpassung von Leistungspegeln.

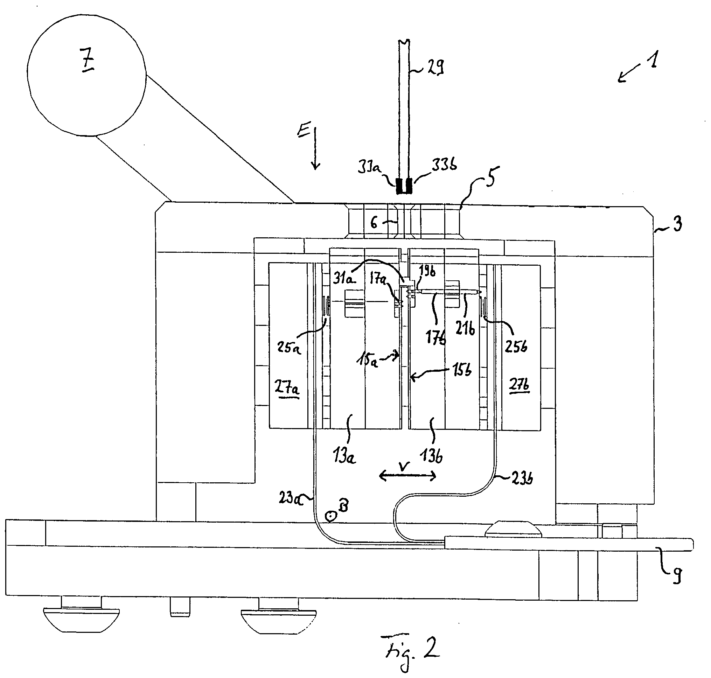

Figur 2 zeigt einen Schnitt durch den in Figur 1 gezeigten Testkontaktor 1 in der Geschlossenposition. Der Testkontaktor 1 weist ein erstes Andruckelement 13a mit einer ersten Leiterplattenkontaktseite 15a auf. Weiter umfaßt das erste Andruckelement 13a zumindest ein erstes Kontaktelement 17a, insbesondere eine Vielzahl von ersten Kontaktelementen 17a. Des weiteren weist der Testkontaktor 1 ein zweites Andruckelement 13b mit einer zweiten Leiterplattenkontaktseite 15b und zumindest einem zweiten Kontaktelement 17b, insbesondere einer Vielzahl von zweiten Kontaktelementen 17b auf. Das erste Andruckelement 13a und das zweite Andruckelement 13b sind entlang einer Verlagerungsrichtung V relativ zueinander verlagerbar, insbesondere linear verschiebbar.

Die ersten Kontaktelemente 17a und die zweiten Kontaktelemente 17b sind in dieser bevorzugten Ausführungsform rückstellfähig ausgebildet. Dabei umfaßt ein beispielhaftes zweites Kontaktelement 17b einen Kontaktstift 19b und eine Kontakthülse 21b, wobei der Kontaktstift 19b teilweise in die Kontakthülse 21b eingeführt und darin federnd gelagert ist. Dazu ist in der Kontakthülse 21b bevorzugt eine spiralförmige Kontaktfeder (nicht gezeigt) angeordnet, so daß der Kontaktstift 19b weiter in die Kontakthülse 21b eindrückbar ist, wobei die Kontaktfeder dadurch eine entsprechende Gegenkraft erzeugt. Die Kraft, die notwendig ist, um den Kontaktstift 19b um eine vorbestimmte Weglänge in die Kontakthülse 21b einzudrücken, wird durch die Federkonstante der Kontaktfeder vorbestimmt. Das Kontaktelement 17b ist über die Kontakthülse 21b an dem zweiten Andruckelement 13b befestigt. Dazu kann das Andruckelement 13b eine entsprechende Bohrung aufweisen, in welche die Kontakthülse 21b zumindest bereichsweise aufgenommen werden kann. Zum Befestigen kann es ausreichend sein, die Kontakthülse 21b lediglich in eine Bohrung bzw. Sackbohrung zu stecken, wobei die Kontakthülse 21b mit dem zweiten Andruckelement 13b in Reibschluß gelangt. Weiter kann die Kontakthülse 21b mit dem zweiten Andruckelement 13b verklebt oder auf andere Weise verbunden sein. Das erste Kontaktelement 17a kann in entsprechender Weise ausgebildet und an dem ersten Andruckelement 13a befestigt sein.

Die durch das erste Andruckelement 13a aufgenommenen ersten Kontaktelemente 17a sind mittels einer flexiblen ersten elektrischen Leitung 23a mit der Testkontaktorleiterplatte 9 elektrisch verbunden. Dabei ist bevorzugt jedes einzelne der ersten Kontaktelemente 17a mit einem eindeutig zugeordneten Kontaktbereich der Testkontaktorleiterplatte 9 kontaktiert. Die zweiten Kontaktelemente 17b, welche durch das zweite Andruckelement 13b aufgenommen sind, sind mittels einer flexiblen zweiten elektrischen Leitung 23b mit der Testkontaktorleiterplatte 9 elektrisch verbunden. Auch hier ist bevorzugt jeder der zweiten Kontaktelemente 17b mit einem eindeutig zugeordneten Kontaktbereich der Testkontaktorleiterplatte 9 kontaktiert. Bevorzugt sind die erste elektrische Leitung 23a und die zweite elektrische Leitung 23b gleich lang. Dadurch können vorteilhafterweise Phasenverzögerungen von Signalen vermieden werden, welche zeitgleich an einem ersten Kontaktelement 17a und einem zweiten Kontaktelement 17b anliegen und über die entsprechende erste elektrische Leitung 23a und zweite elektrische Leitung 23b zur Testkontaktorleiterplatte 9 übertragen werden, so daß diese Signale phasenrichtig von der Testkontaktorleiterplatte 9 empfangen werden.

Bevorzugt kann die erste elektrische Leitung 23a eine Trägerfolie umfassen, welche durch Beschichten mit elektrischen Leitern versehen ist. Eine solche Trägerfolie kann im wesentlichen die gleiche Breite aufweisen wie das erste Andruckelement 13a, mit welchem die erste elektrische Leitung 23a verbunden ist. Die Trägerfolie der ersten elektrischen Leitung 23a ist derart angeordnet, daß sich die Trägerfolie in einer Breitenrichtung B erstreckt, welche im wesentlichen senkrecht zur Verlagerungsrichtung V und senkrecht zur Einführrichtung E steht. Bei einer Verlagerung des ersten Andruckelements 13a entlang der Verlagerungsrichtung V wird die Trägerfolie der ersten elektrischen Leitung 23a lediglich entlang einer Biegeachse parallel zur Breitenrichtung B gebogen. Die zweite elektrische Leitung 23b ist entsprechend ausgebildet und angeordnet.

Der Testkontaktor 1 umfaßt eine erste Vorspanneinrichtung 25a, welche das erste Andruckelement 13a gegenüber einem ersten Widerlager 27a des Testkontaktors 1 entlang der Verlagerungsrichtung V mechanisch vorspannt. Dementsprechend wird das zweite Andruckelement 13b mittels einer zweiten Vorspanneinrichtung 25b gegenüber einem zweiten Widerlager 27b entlang der Verlagerungsrichtung V mechanisch vorgespannt. Die erste und zweite Vorspanneinrichtung 25a, 25b umfassen bevorzugt Spiralfedern, welche zwischen dem ersten Andruckelement 13a und dem ersten Widerlager 27a bzw. zwischen dem zweiten Andruckelement 13b und dem zweiten Widerlager 27b angeordnet sind. Die mechanische Vorspannung mittels der ersten und zweiten Vorspanneinrichtungen 25a, 25b führt dazu, daß der Testkontaktor 1 ohne äußere Einwirkung in der in Figur 2 gezeigten Geschlossenposition verbleibt.

In der Geschlossenposition ist der Abstand zwischen dem ersten Andruckelement 13a und dem zweiten Andruckelement 13b bevorzugt derart gewählt, daß die ersten Kontaktelemente 17a weder die gegenüberliegenden zweiten Kontaktelemente 17b noch die gegenüberliegende zweite Leiterplattenkontaktseite 15b kontaktieren. Dementsprechend kontaktieren die zweiten Kontaktelemente 17b in der Geschlossenposition vorzugsweise nicht die gegenüberliegende erste Leiterplattenkontaktseite 15a. Dennoch kann der Abstand zwischen der ersten Leiterplattenkontaktseite 15a und der zweiten Leiterplattenkontaktseite 15b derart vorbestimmt sein, daß eine Leiterplatte 19 in der Geschlossenposition nicht zwischen das erste Andruckelement 13a und das zweite Andruckelement 13b eingeführt werden kann. Dazu beträgt der lichte Abstand zwischen der ersten Leiterplattenkontaktseite 15a und der zweiten Leiterplattenkontaktseite 15b auf Höhe der ersten Kontaktelemente 17a weniger als 1 mm.

Alternativ kann der Abstand zwischen dem ersten Andruckelement 13a und dem zweiten Andruckelement 13b in der Geschlossenposition bevorzugt gleich null sein, Die ersten Kontaktelemente 17a und die zweiten Kontaktelemente 17b sind dann elastisch verformt. Beispielsweise können die einzelnen Kontaktstifte der Kontaktelemente in die zugehörigen Kontakthülse eingeschoben sein.

Um das Einführen auf einer ungeeigneten Leiterplatte 29 in einen in Offenposition befindlichen Testkontaktor 1 zu verhindern, kann das erste Andruckelement 13a mit zumindest einem ersten Sicherungsstift 31a versehen sein, welcher über die erste Leiterplattenkontaktseite 15a entlang der Verlagerungsrichtung V vorragt, wobei in dem gegenüberliegenden zweiten Andruckelement 13b eine komplementäre Sicherungsstiftöffnung ausgebildet ist (nicht gezeigt), in welcher der erste Sicherungsstift 31a hineinragen kann. Bevorzugt überspannt der erste Sicherungsstift 31a den Abstand d_{O} zwischen der ersten Leiterplattenkontaktseite 15a und der zweiten Leiterplattenkontaktseite 15b sowohl in der Geschlossenposition, der Betriebsposition und der Offenposition. Der erste Sicherungsstift 31a ist im Bereich der Leiterplatteneinführöffnung 5 angeordnet, so daß die ersten Kontaktelemente 17a vom ersten Sicherungsstift 31a aus gesehen in Richtung der Einführrichtung E angeordnet sind. Entsprechend kann ein zweiter Sicherungsstift (nicht gezeigt) vorgesehen sein, welcher an der zweiten Leiterplattenkontaktseite 15b angeordnet bzw. befestigt ist und über diese entlang der Verlagerungsrichtung V vorragt, um in eine komplementäre Sicherungsstiftöffnung des gegenüberliegenden ersten Andruckelements 13a hineinzuragen. Entsprechend können auch 2, 3, 4 oder mehr erste und/oder zweite Sicherungsstifte vorgesehen sein. Der zumindest eine erste Sicherungsstift 31a kann starr an dem ersten Andruckelement 13a angebracht sein und entsprechend kann der zumindest eine zweite Sicherungsstift starr an dem zweiten Andruckelement 13b angebracht sein.

Aufgrund der Anordnung des zumindest einen Sicherungsstifts 31a und/oder des zumindest einen zweiten Sicherungsstifts können nur Leiterplatten 29 mit dem Testkontaktor 1 kontaktiert werden, welche zu der Position des Sicherungstifts 31a bzw. der Sicherungsstifte entsprechende Kerbungen aufweisen. Beispielsweise können Sicherungstifte derart vorgesehen sein, daß lediglich Leiterplatten 29 mit einem Randbereich in den Testkontaktor 1 einführbar sind, welche der Norm Q7 entsprechen. Der in der Figur 2 gezeigte zumindest eine erste Sicherungsstift 31a kann in eine Kerbung der Leiterplatte 29 entgegen der Einführrichtung E eingeführt werden, so daß die Leiterplatte 29 entlang der Einführrichtung E derart in den Testkontaktor 1 einführbar ist, bis der erste Sicherungsstift 31a gegen die Kante der Kerbung in der Leiterplatte 29 anstößt, wobei anschließend die ersten Kontaktelemente 17a mit den zugeordneten ersten Platinenrandkontakten 33a der Leiterplatten 29 kontaktieren können, wenn der Testkontaktor nach dem Einführen der Leiterplatte 29 in die Betriebsposition überführt wird.

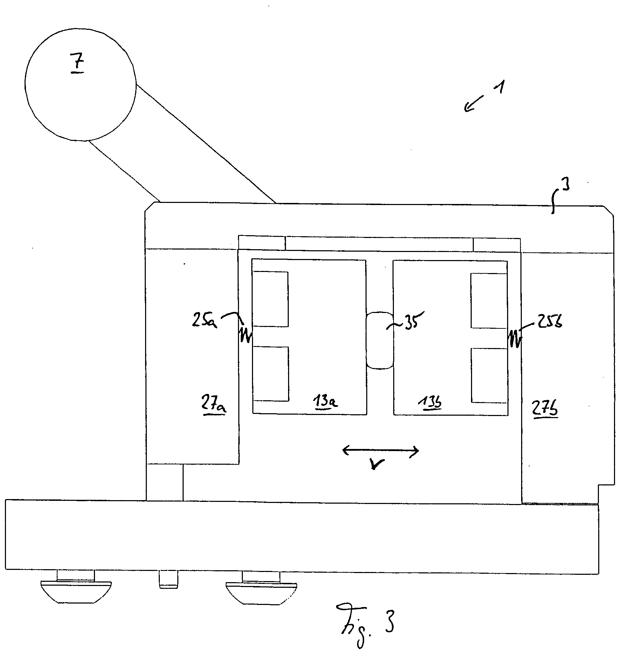

Um den Testkontaktor 1 zum Einführen der Leiterplatte 29 in einer Offenposition zu überführen, weist der Testkontaktor 1 eine Betätigungseinrichtung auf, mit welcher das erste Andruckelement 13a und das zweite Andruckelement 13b relativ zueinander entlang der Verlagerungsrichtung V verlagerbar sind. Figur 3 zeigt einen Schnitt durch eine beispielhafte Betätigungseinrichtung des Testkontaktors 1. Die beispielhafte Betätigungseinrichtung umfaßt zwei exzentrische Kurvenscheiben 35, welche in Breitenrichtung an gegenüberliegenden Seiten jeweils zwischen dem ersten Andruckelement 13a und dem zweiten Andruckelement 13b angeordnet sind. Die Figur 3 zeigt eine exzentrische Kurvenscheibe 35 an einer Seite des Testkontaktors 1. Die exzentrische Kurvenscheibe 35 kann mittels eines Achsstummels (nicht gezeigt) im Gehäuse 3 des Testkontaktors 1 gelagert sein, beispielsweise mittels eines Kugellagers oder einer reibungsarmen Kunststoffhülse. Dadurch ist die Kurvenscheibe 35 drehbar gelagert, wobei die exzentrische Kurvenscheibe 35 durch ein Betätigen des Betätigungshebels 7 drehbar ist. Mit anderen Worten ist der Betätigungshebel 7 bevorzugt an der Außenseite des Gehäuses 3 mit dem Achsstummel bzw. der Kurvenscheibe 35 mechanisch verbunden. Ausgehend von der Geschlossenposition kann der Durchmesser der Kurvenscheibe 35 durch ein Betätigen des Betätigungshebels 7 und dem damit verbundenen Drehen der Kurvenscheibe vergrößert werden, so daß das erste und zweite Andruckelement 13a, 13b in entgegengesetzte Richtungen entlang der Verlagerungsrichtung V und entgegen der mechanischen Spannung, welche von der ersten und zweiten Vorspanneinrichtung 25a, 25b gegenüber dem ersten und zweiten Widerlager 27a, 27b erzeugt wird. Durch das Niederdrücken des Betätigungshebels 7 gelangt der Testkontaktor in die Offenposition.

In der Offenposition ist zwischen der ersten Leiterplattenkontaktseite 15a und der zweiten Leiterplattenkontaktseite 15b im Bereich der ersten Kontaktelemente 17a entlang der Verlagerungsrichtung V ein Abstand d_{O} ausgebildet, der ausgelegt ist, daß die Leiterplatte 29 zwischen der ersten Leiterplattenkontaktseite und der zweiten Leiterplattenkontaktseite 15b zumindest bereichsweise entlang einer Einführrichtung E kontaktfrei einführbar ist. Bevorzugt kann der Abstand d_{O} um den Faktor 2, weiter bevorzugt um den Faktor 5 oder insbesondere um einen Faktor größer als 10 größer sein als die Dicke der zu prüfenden Leiterplatte. Mit anderen Worten kann der Abstand d_{O} beispielsweise etwa 3 mm, etwa 4 mm, etwa 5 mm, oder etwa 10 mm betragen. Insbesondere ist der Abstand d_{O} derart vorbestimmt, daß die ersten Kontaktelemente 17a und die zweiten Kontaktelemente 17b voneinander derart beabstandet sind, daß die zu prüfenden Leiterplatte kontaktfrei einführbar ist. Insbesondere ist der Abstand d_{K} der ersten Kontaktelemente 17a und der zweiten Kontaktelemente 17b in der Offenposition größer als die Breite der Einführnuten 6 der Einführöffnung 5 entlang der Verlagerungsrichtung V. Weiter bevorzugt kann der Abstand d_{K} der ersten Kontaktelemente 17a und der zweiten Kontaktelemente 17b in der Offenposition größer als die Breite der Einführöffnung 5 entlang der Verlagerungsrichtung V sein. Der Abstand zwischen den ersten Kontaktelementen 17a und den zweiten Kontaktelementen 17b erlaubt ein Einführen der Leiterplatte 29, ohne das zwischen der Leiterplatte 29 und den ersten Kontaktelementen 17a oder den zweiten Kontaktelementen 17b ein mechanischer bzw. elektrischer Kontakt auftritt, wodurch eine Reibung zwischen der Leiterplatte und den ersten und zweiten Kontaktelementen 17a, 17b verhindert wird. Vorteilhafterweise tritt dadurch keine Abrasion zwischen den Kontaktelemente auf. In der Offenposition kann die in Figur 2 gezeigte Leiterplatte 29 durch die Leiterplatteneinführöffnung 5 des Gehäuses 3 zumindest mit ihrem Randbereich in den Testkontaktor 1 entlang der Einführrichtung E eingeführt werden. Für den Fall, daß der Testkontaktor 1 mit einem ersten Sicherungsstift 31a ausgestattet ist, der eine Länge aufweist, so daß der erste Sicherungsstift 31a auch in der Offenposition den Zwischenraum zwischen dem ersten Andruckelement 13a und dem zweiten Andruckelement 13b überbrückt, muß die Leiterplatte 29 mit einer entsprechend positionierten Kerbe ausgestattet sein, damit die Leiterplatte 29 in den Zwischenraum zwischen dem ersten Andruckelement 13a und dem zweiten Andruckelement 13b eingeführt werden kann. Für den Fall, daß der erste Sicherungsstift 31a nicht mittig entlang der Breite des ersten Andruckelements 13a angeordnet ist, kann der erste Sicherungsstift 31a ebenfalls als Verpolungsschutz dienen, da die Leiterplatte 29 dann nur in einer eindeutigen Weise durch die Leiterplatteneinführöffnung 5 in den Testkontaktor 1 eingeführt werden kann.

Nach dem Einführen der Leiterplatte 29 in den Testkontaktor 1, kann der Testkontaktor 1 durch ein Loslassen des Betätigungshebels 7 von der Offenposition in eine Betriebsposition überführt werden. Nach dem Loslassen des Betätigungshebels 7 werden das erste und zweite Andruckelement 13a, 13b mittels der ersten und zweiten Vorspanneinrichtung 25a, 25b entlang der Verlagerungsrichtung V zueinander verlagert. In der Betriebsposition existiert zwischen der ersten Leiterplattenkontaktseite 15a und der zweiten Leiterplattenkontaktseite 15b im Bereich der ersten Kontaktelemente 17a entlang der Verlagerungsrichtung V ein Abstand D_{B}, der kleiner ist als der Abstand D_{O} in der Offenposition. Dadurch kontaktieren die ersten Kontaktelemente 17a jeweils zugeordnete erste Platinenrandkontakte 33a der Leiterplatte 29. Bevorzugt kontaktieren die zweiten Kontaktelemente 17b die zugeordneten zweiten Platinenrandkontakte 33b der Leiterplatte 29a. In der Betriebsposition üben die ersten Kontaktelemente 17a jeweils eine vorbestimmte Andruckkraft F_{K} auf die zugeordneten Platinenrandkontakte 33a aus. Dementsprechend üben die zweiten Kontaktelemente 17b eine vorbestimmte Andruckkraft F_{K} auf die zugeordneten Platinenrandkontakte 33b der Leiterplatte 29 aus. Dementsprechend ist der lichte Abstand zwischen den ersten Kontaktelementen 17a und den zweiten Kontaktelementen 17b in der Betriebsposition größer als der lichte Abstand zwischen beiden in der Geschlossenposition des Testkontaktors 1. Der lichte Abstand zwischen den ersten Kontaktelementen 17a und den zweiten Kontaktelementen 17b in der Betriebsposition ist dabei lediglich abhängig von der Dicke der Leiterplatte 29. Bevorzugt legt jedes einzelne der ersten Kontaktelemente 17a oder der zweiten Kontaktelemente 17b eine Andruckkraft F_{K} von etwa 0,05 N bis etwa 0,5 N, weiter bevorzugt 0,1 N bis etwa 0,3 N, insbesondere 0,2 N an die Leiterplatte 29 an. Die ersten und die zweiten Platinenrandkontakte 33a, 33b sind in der Betriebsposition über die ersten und zweiten Kontaktelemente 17a, 17b und die erste und zweite elektrische Leitung 23a, 23b mit der Testkontaktleiterplatte 9 elektrisch verbunden. Über eine Schnittstelle der Testkontaktorleiterplatte 9 kann die Leiterplatte 29 mit einem externen Prüfgerät (nicht gezeigt) kontaktiert werden, um die Prüfung der Leiterplatte durchzuführen. Nach dem Durchführen der Prüfung, wird der Testkontaktor 1 wieder in die Offenposition durch Betätigen des Betätigungshebels 7 überführt, um die Leiterplatte 29 kraftfrei entgegen der Einführrichtung E aus dem Testkontaktor 1 zu entfernen.

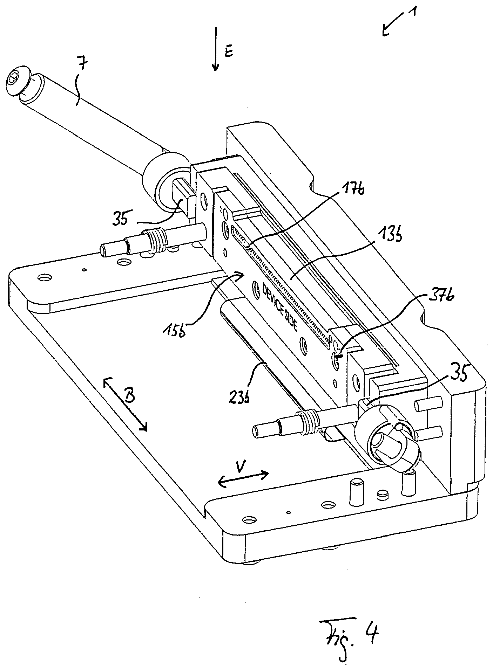

Figur 4 zeigt eine Explosionsteilansicht einer weiteren Ausführungsform eines Testkontaktors 1, welcher neben den im folgenden beschriebenen Merkmalen alle Merkmale aufweist, welche bereits im Hinblick auf die Figuren 1 bis 3 beschrieben wurden. Identische Merkmale sind daher mit den in den Figuren 1 bis 3 benutzten Bezugszeichen bezeichnet und auf die zu den Figuren 1 bis 3 gehörige Beschreibung wird verwiesen.

Figur 4 zeigt ein bevorzugtes zweites Andruckelement 13b, welches auf der zweiten Leiterplattenkontaktseite 15b neben einer Vielzahl von zweiten Kontaktelementen 17b auch zumindest ein zweites Massekontaktelement 37b aufweist, welches ausgehend von der zweiten Leiterplattenkontaktseite 15b entlang der Verlagerungsrichtung V weiter vorragt als die zweiten Kontaktelemente 17b. Entsprechend kann das nicht gezeigte erste Andruckelement zumindest ein erstes Massekontaktelement aufweisen, welches ausgehend von der ersten Leiterplattenkontaktseite entlang der Verlagerungsrichtung V weiter vorragt als die ersten Kontaktelemente.

In der Offenposition des Testkontaktors verbleibt zwischen dem ersten Andruckelement und dem zweiten Andruckelement 13b ein lichter Abstand, so daß eine Leiterplatte (nicht gezeigt) kontaktfrei bzw. reibungsfrei eingeführt werden kann, auch, wenn der Testkontaktor 1 zumindest ein erstes Massekontaktelement und/oder zumindest ein zweites Massekontaktelement 37b aufweist. In einer bevorzugten Ausführungsform des Testkontaktors ist der lichte Abstand zwischen dem zumindest einen ersten Massekontaktelement und dem zumindest einen zweiten Massekontaktelement 37b geringer als der lichte Abstand zwischen dem zumindest einen ersten Kontaktelement und dem zumindest einen zweiten Kontaktelement, jeweils entlang der Verlagerungsrichtung V.

Insbesondere ist der Abstand d_{O} in der Offenposition derart vorbestimmt, daß das zumindest eine erste Massekontaktelement und das zumindest eine zweite Massekontaktelement 37b voneinander derart beabstandet sind, daß die zu prüfenden Leiterplatte kontaktfrei einführbar ist. Insbesondere ist ein Abstand d_{M} zwischen erstem Massekontaktelement und zweitem Massekontaktelement 37b in der Offenposition größer als die Breite der Einführnuten 6 der Einführöffnung 5 entlang der Verlagerungsrichtung V und weiter bevorzugt größer als die Breite der Einführöffnung 5 entlang der Verlagerungsrichtung V. Mit anderen Worten kann der Abstand d_{M} beispielsweise größer als etwa 2 mm, größer als etwa 3 mm, größer als etwa 5 mm, oder größer als etwa 10 mm sein. Insbesondere kann kann der Abstand d_{M} beispielsweise 2,7 mm betragen.

Vorteilhafterweise erfolgt beim Übergang des Testkontaktors 1 von der Offenposition in die Betriebsposition eine elektrische Kontaktierung des zumindest einen ersten Massekontaktelements mit einem zugeordneten ersten Platinenrandmassekontakt (nicht gezeigt) der zu prüfenden Leiterplatte bzw. eine elektrische Kontaktierung des zumindest einen zweiten Massekontaktelements 37b mit einem zugeordneten zweiten Platinenrandmassekontakt (nicht gezeigt) bevor das zumindest eine zweite Kontaktelement 17b dem zugeordneten ersten Platinenrandkontakt der Leiterplatte elektrisch kontaktiert. Dadurch wird die prüfende Leiterplatte zuerst mit Masse bzw. mit dem Nullpotential elektrisch verbunden, bevor spannungsführende erste und/oder zweite Kontaktelemente 17a, 17b des Testkontaktors 1 mit der Leiterplatte 29 in elektrischem Kontakt treten können, wodurch eine Beschädigung der Leiterplatte durch Spannungsspitzen beim Kontaktieren vermieden werden können.

### Bezugszeichenliste

- 1: Testkontaktor
- 3: Gehäuse
- 5: Leiterplatteneinführöffnung
- 6: Einführnuten
- 7: Betätigungshebel
- 9: Testkontaktorleiterplatte
- 11: Schnittstelle
- 13a: erstes Andruckelement
- 13b: zweites Andruckelement
- 15a: erste Leiterplattenkontaktseite
- 15b: zweite Leiterplattenkontaktseite
- 17a: erstes Kontaktelement
- 17b: zweites Kontaktelement
- 19b: Kontaktstift
- 21b: Kontakthülse
- 23a: erste elektrische Leitung
- 23b: zweite elektrische Leitung
- 25a: erste Vorspanneinrichtung
- 25b: zweite Vorspanneinrichtung
- 27a: erstes Widerlager
- 27b: zweites Widerlager
- 29: Leiterplatte
- 31a: erster Sicherungsstift
- 33a: erste Platinenrandkontakte
- 33b: zweite Platinenrandkontakte
- 35: Kurvenscheibe
- 37b: zweites Massekontaktelement

## Patentansprüche

1. Testkontaktor (1) zum Kontaktieren einer Leiterplatte (29) umfassend:
- ein erstes Andruckelement (13a) mit
- - einer ersten Leiterplattenkontaktseite (15a),
- - zumindest einem ersten Kontaktelement (17a) und
- - zumindest einem rückstellfähig ausgebildeten, ersten Massekontaktelement;
- ein zweites Andruckelement (13b) mit einer zweiten Leiterplattenkontaktseite (15b), wobei das zweite Andruckelement (13b) relativ zu dem ersten Andruckelement (13a) entlang einer Verlagerungsrichtung (V) verlagerbar ist,
wobei in einer Offenposition die erste Leiterplattenkontaktseite (15a) um einen Abstand d_{O} von der zweiten Leiterplattenkontaktseite (15b) im Bereich des zumindest einen ersten Kontaktelements (17a) entlang der Verlagerungsrichtung (V) beabstandet ist, so daß die Leiterplatte (29) zwischen der ersten Leiterplattenkontaktseite (15a) und der zweiten Leiterplattenkontaktseite (15b) zumindest bereichsweise entlang einer Einführrichtung (E) kontaktfrei einführbar ist,
wobei in einer Betriebsposition die erste Leiterplattenkontaktseite (15a) um einen Abstand d_{B} von der zweiten Leiterplattenkontaktseite (15b) im Bereich des zumindest einen ersten Kontaktelements (17a) entlang der Verlagerungsrichtung (V) beabstandet ist, der kleiner als der Abstand d_{O} ist, so daß das zumindest eine erste Kontaktelement (17a) mit zumindest einem zugeordneten ersten Platinenrandkontakt (33a) der Leiterplatte (29) kontaktierbar ist,
wobei das zumindest eine erste Massekontaktelement ausgehend von der ersten Leiterplattenkontaktseite (15a) entlang der Verlagerungsrichtung (V) weiter vorragt als das zumindest eine erste Kontaktelement (17a) und
wobei der Testkontaktor (1) durch eine relative Verlagerung der zwei Andruckelemente (13a, 13b) entlang der Verlagerungsrichtung (V) von der Offenposition in die Betriebsposition überführbar ist.

2. Testkontaktor (1) gemäß Anspruch 1, wobei das zweite Andruckelement (13b) zumindest ein zweites Kontaktelement (17b) umfaßt, wobei das zumindest eine zweite Kontaktelement (17b) in der Betriebsposition mit zumindest einem zugeordneten zweiten Platinenrandkontakt (33b) der Leiterplatte kontaktierbar ist.

3. Testkontaktor (1) gemäß Anspruch 1 oder 2,
wobei das zweite Andruckelement (13b) zumindest ein zweites Massekontaktelement (37b) aufweist, welches ausgehend von der zweiten Leiterplattenkontaktseite (15b) entlang der Verlagerungsrichtung (V) weiter vorragt als das zumindest eine zweite Kontaktelement (17b).

4. Testkontaktor (1) gemäß einem der vorigen Ansprüche, wobei das zumindest eine erste Kontaktelement (17a) und/oder das zumindest eine zweite Kontaktelement (17b) rückstellfähig ausgebildet sind und
wobei das zumindest eine erste Kontaktelement (17a) und/oder das zumindest eine zweite Kontaktelement (17b) in der Betriebsposition eine vorbestimmte Andruckkraft (F_{K}) auf die Leiterplatte (29) anlegt.

5. Testkontaktor (1) gemäß einem der vorigen Ansprüche, wobei das zumindest eine erste Kontaktelement (17a) mittels einer flexiblen ersten elektrischen Leitung (23a) mit einer Testkontaktorleiterplatte (9) elektrisch verbunden ist.

6. Testkontaktor (1) gemäß Anspruch 5, wobei das zumindest eine zweite Kontaktelement (17b) mittels einer flexiblen zweiten elektrischen Leitung (23b) mit der Testkontaktorleiterplatte (9) elektrisch verbunden ist und wobei die zweite elektrische Leitung (23b) gleich lang zu der ersten elektrischen Leitung (23a) ist.

7. Testkontaktor (1) gemäß einem der vorigen Ansprüche, weiter umfassend:
- eine erste Vorspanneinrichtung (25a), welche das erste Andruckelement (13a) entlang der Verlagerungsrichtung (V) mechanisch vorspannt
und/oder
- eine zweite Vorspanneinrichtung (25b), welche das zweite Andruckelement (13b) entlang der Verlagerungsrichtung (V) mechanisch vorspannt.

8. Testkontaktor (1) gemäß einem der vorigen Ansprüche, weiter umfassend:
- eine Betätigungseinrichtung (7, 35), mit welcher das erste Andruckelement (13a) und/oder das zweite Andruckelement (13b) verlagerbar ist.

9. Verwendung eines Testkontaktors (1) gemäß einem der Ansprüche 1 bis 8 zum Kontaktieren einer Leiterplatte (3), wobei in der Betriebsposition das zumindest eine erste Kontaktelement (17a) des erstes Andruckelements (13a) mit zumindest einem zugeordneten ersten Platinenrandkontakt (33a) der Leiterplatte (29) kontaktiert ist.

10. Verfahren zum Prüfen einer Leiterplatte (29) umfassend die Schritte:
- Bereitstellen eines Testkontaktors (1) gemäß einem der Ansprüche 1 bis 8;
- kraftfreies Anordnen zumindest eines Randbereiches der Leiterplatte (29) zwischen dem ersten Andruckelement (13a) und dem zweiten Andruckelement (13b) des Testkontaktors (1);
- Verlagern des ersten Andruckelements (13a) entlang der Verlagerungsrichtung (V) relativ zu dem zweiten Andruckelement (13b), um den Testkontaktor (1) in eine Betriebsposition zu überführen, wobei das zumindest eine erste Kontaktelement (17a) mit zumindest einem zugeordneten ersten Platinenrandkontakt (33a) der Leiterplatte (29) kontaktiert wird;
- Prüfen der Leiterplatte (29);
- Verlagern des ersten Andruckelements (13a) entlang der Verlagerungsrichtung (V) relativ zu dem zweiten Andruckelement (13b), um den Testkontaktor (1) in eine Offenposition zu überführen und
- kraftfreies Entnehmen der Leiterplatte (29).

## Claims

1. A test contactor (1) for contacting a printed circuit board (29) comprising:
- A first pressure element (13a) with
- A first printed circuit board contact side (15a),
- At least one first contact element (17a) and
- At least one first ground contact element designed to be resettable;
- A second pressure element (13b) with a second printed circuit board contact side (15b), wherein the second pressure element (136) can be shifted relative to the first pressure element (13a) along a displacement direction (V),
Wherein in an open position, the first printed circuit board contact side (15a) is spaced a distance do from the second printed circuit board contact side (15b) in the region of the at least one first contact element (17a) along the displacement direction (V) so that the printed circuit board (29) can be introduced free of contact between the first printed circuit board contact side (15a) and the second printed circuit board contact side (15b) at least sectionally along a direction of introduction (E),
Wherein in an operating position, the first printed circuit board contact side (15a) is spaced a distance d_{B} from the second printed circuit board contact side (15b) in the region of the at least one first contact element (17a) along the displacement direction (V) which is smaller than distance do so that the at least one first contact element (17a) can be contacted with at least one associated first circuit board edge contact (33a) of the printed circuit board (29),
Wherein the at least one first ground contact element, proceeding from the first printed circuit board contact side (15a), protrudes further along the displacement direction (V) than the at least one first contact element (17a), and wherein the test contactor (1) can be transferred by a relative displacement of the two pressure elements (13a, 13b) along the displacement direction (V) from the open position into the operating position.

2. The test contactor (1) according to claim 1, wherein the second pressure element (13b) comprises at least one second contact element (17b), wherein the at least one second contact element (17b) can be contacted in the operating position with at least one associated second circuit board edge contact (33b) of the printed circuit board.

3. The test contactor (1) according to claim 1 or 2, wherein the second pressure element (13b) has at least one second ground contact element (37b) that, starting from the second printed circuit board contact side (15b) protrudes further along the displacement direction (V) than the at least one second contact element (17b).

4. The test contactor (1) according to one of the preceding claims, wherein the at least one first contact element (17a), and/or the at least one second contact element (17b) are designed to be resettable, and wherein the at least one first contact element (17a) and/or the at least one second contact element (17b) in the operating position applies a predetermined pressure (F_{K}) to the printed circuit board (29).

5. The test contactor (1) according to one of the preceding claims, wherein the at least one first contact element (17a) is electrically connected by means of a flexible, first electrical line (23a) to a test contactor printed circuit board (9).

6. The test contactor (1) according to claim 5, wherein the at least one second contact element (17b) is electrically connected by means of a flexible second electrical line (23b) to the test contactor printed circuit board (9), and wherein the second electrical line (23b) is the same length as the first electrical line (23a).

7. A test contactor (1) according to one of the prior claims, furthermore comprising:
- A first pretensioning apparatus (25a) that mechanically pretensions the first pressure element (13a) along a displacement direction (V)
and/or
- A second pretensioning apparatus (25b) that mechanically pretensions the second pressure element (13b) along the displacement direction (V).

8. The test contactor (1) according to one of the preceding claims, furthermore comprising: An actuating apparatus (7, 35) by means of which the first pressure element (13a) and/or the second pressure (13b) element can be displaced.

9. A use of a test contactor (1) according to one of claims 1 to 8 for contacting a printed circuit board (3), wherein in the operating position, the at least one first contact element (17a) of the first pressure element (13a) is in contact with at least one associated first circuit board edge contact (33a) of the printed circuit board (29).

10. A method for testing a printed circuit board (29) comprising the steps:
- Providing a test contactor (1) according to one of claims 1 to 8;
- Arranging without force at least one edge region of the printed circuit board (29) between the first pressure element (13a) and the second pressure element (13b) of the test contactor (1);
- Displacing the first pressure element (13a) along the displacement direction (V) relative to the second pressure element (13b) in order to transfer the test contactor (1) into an operating position, wherein the at least one first contact element (17a) is contacted by at least one associated first circuit board edge contact (33a) of the printed circuit board (29);
- Testing the printed circuit board (29);
- Displacing the first pressure element (13a) along the direction of displacement (V) relative to the second pressure element (13b) in order to transfer the test contactor (1) into an open position, and
- Removing the printed circuit board (29) without force.

## Revendications

1. Contacteur d'essai (1) pour la mise en contact d'une plaquette à circuits imprimés (29), comportant :
- un premier élément de pression (13a) avec
- un premier côté de contact de plaquette à circuits imprimés (15a),
- au moins un premier élément de contact (17a) et
- au moins un premier élément de contact de masse conçu de façon résiliente ;
- un deuxième élément de pression (13b) avec un deuxième côté de contact de plaquette à circuits imprimés (15b), le deuxième élément de pression (13b) étant déplaçable par rapport au premier élément de pression (13a) le long d'une direction de déplacement (V),
dans lequel, dans la position ouverte, le premier côté de contact de plaquette à circuits imprimés (15a) est espacé du deuxième côté de contact de plaquette à circuits imprimés (15b) d'une distance do dans la région de l'au moins un premier élément de contact (17a) le long de la direction de déplacement (V), de telle façon que la plaquette à circuits imprimés (29) peut être insérée au moins par endroits sans contact le long d'une direction d'insertion (E) entre le premier côté de contact de plaquette à circuits imprimés (15a) et le deuxième côté de contact de plaquette à circuits imprimés (15b),
dans lequel, dans la position de fonctionnement, le premier côté de contact de plaquette à circuits imprimés (15a) est espacé du deuxième côté de contact de plaquette à circuits imprimés (15b) d'une distance d_{B} dans la région de l'au moins un premier élément de contact (17a) le long de la direction de déplacement (V), laquelle est inférieure à la distance do, de telle façon que l'au moins un premier élément de contact (17a) peut être mis en contact avec au moins un premier contact de bord de platine (33a) correspondant de la plaquette à circuits imprimés (29),
dans lequel l'au moins un premier élément de contact de masse fait saillie plus loin le long de la direction de déplacement (V) à partir du premier côté de contact de plaquette à circuits imprimés (15a) que l'au moins un premier élément de contact (17a) et
dans lequel le contacteur d'essai (1) peut être transféré de la position ouverte vers la position de fonctionnement par un déplacement relatif des deux éléments de pression (13a, 13b) le long de la direction de déplacement (V).

2. Contacteur d'essai (1) selon la revendication 1, dans lequel le deuxième élément de pression (13b) comporte au moins un deuxième élément de contact (17b), l'au moins un deuxième élément de contact (17b) pouvant être mis en contact avec au moins un deuxième contact de bord de platine (33b) correspondant de la plaquette à circuits imprimés dans la position de fonctionnement.

3. Contacteur d'essai (1) selon la revendication 1 ou 2,
dans lequel le deuxième élément de pression (13b) présente au moins un deuxième élément de contact de masse (37b), lequel fait saillie plus loin le long de la direction de déplacement (V) à partir du deuxième côté de contact de plaquette à circuits imprimés (5) que l'au moins un deuxième élément de contact (17b).

4. Contacteur d'essai (1) selon l'une des revendications précédentes, dans lequel l'au moins un premier élément de contact (17a) et/ou l'au moins un deuxième élément de contact (17b) sont conçus de façon résiliente et
dans lequel l'au moins un premier élément de contact (17a) et/ou l'au moins un deuxième élément de contact (17b) applique/appliquent une force de pression (F_{K}) prédéterminée sur la plaquette à circuits imprimés (29) dans la position de fonctionnement.

5. Contacteur d'essai (1) selon l'une des revendications précédentes, dans lequel l'au moins un premier élément de contact (17a) est électriquement relié à une plaquette à circuits imprimés de contacteur d'essai (9) au moyen d'une première ligne électrique flexible (23a).

6. Contacteur d'essai (1) selon la revendication 5, dans lequel l'au moins un deuxième élément de contact (17b) est électriquement relié à la plaquette à circuits imprimés de contacteur d'essai (9) au moyen d'une deuxième ligne électrique flexible (23b), et dans lequel la deuxième ligne électrique (23b) est de la même longueur que la première ligne électrique (23a).

7. Contacteur d'essai (1) selon l'une des revendications précédentes, comportant en outre :
- un premier dispositif de précontrainte (25a) chargé de précontraindre le premier élément de pression (13a) mécaniquement le long de la direction de déplacement (V) et/ou
- un deuxième dispositif de précontrainte (25b) chargé de précontraindre le deuxième élément de pression (13b) mécaniquement le long de la direction de déplacement (V).

8. Contacteur d'essai (1) selon l'une des revendications précédentes, comportant en outre :
- un dispositif d'actionnement (7, 35) permettant de déplacer le premier élément de pression (13a) et/ou le deuxième élément de pression (13b).

9. Utilisation d'un contacteur d'essai (1) selon l'une des revendications 1 à 8, pour la mise en contact d'une plaquette à circuits imprimés (3), dans laquelle, dans la position de fonctionnement, l'au moins un premier élément de contact (17a) du premier élément de pression (13a) est mis en contact avec au moins un premier contact de bord de platine (33a) correspondant de la plaquette à circuits imprimés (29).

10. Procédé pour la vérification d'une plaquette à circuits imprimés (29), comportant les étapes suivantes :
- mise à disposition d'un contacteur d'essai (1) selon l'une des revendications 1 à 8 ;
- disposition sans effort d'au moins une région de bord de la plaquette à circuits imprimés (29) entre le premier élément de pression (13a) et le deuxième élément de pression (13b) du contacteur d'essai (1) ;
- déplacement du premier élément de pression (13a) le long de la direction de déplacement (V) par rapport au deuxième élément de pression (13b), pour transférer le contacteur d'essai (1) dans une position de fonctionnement, l'au moins un premier élément de contact (17a) étant mis en contact avec au moins un premier contact de bord de platine (33b) correspondant de la plaquette à circuits imprimés (29) ;
- vérification de la plaquette à circuits imprimés (29) ;
- déplacement du premier élément de pression (13a) le long de la direction de déplacement (V) par rapport au deuxième élément de pression (13b), pour transférer le contacteur d'essai (1) dans une position ouverte, et
- retrait de la plaquette à circuits imprimés (29) sans effort.
